# EUROPEAN PATENT SPECIFICATION

(11) **EP 2 778 702 B1**
(45) Date of publication and mention of the grant of the patent: **04.09.2024**
(21) Application number: 14158236.1
(22) Date of filing: 07.03.2014
(51) Int. Cl.: G01R 31/36, H01M 10/48

(54) **Battery meter and power tool including battery meter**
Batteriemessgerät und motorbetriebenes Werkzeug mit dem Batteriemessgerät
Compteur de batterie et outil électrique le comprenant

(30) Priority: 12.03.2013 JP 2013049629
(43) Date of publication of application: 17.09.2014
(73) Proprietor: Panasonic Intellectual Property Management Co., Ltd., Osaka-shi, Osaka 540-6207 (JP)
(72) Inventor: Okada, Masaaki, Chuo-ku, Osaka 540-6207 (JP); Ikeda, Masaki, Chuo-ku, Osaka 540-6207 (JP)
(74) Representative: Appelt, Christian W.

(56) References cited:
- GB-A- 2 426 390
- JP-B2- 4 772 205
- JP-U- H0 716 364
- US-A1- 2003 137 303
- US-A1- 2006 197 536
- US-B1- 6 437 699

## Description

The present invention relates to a battery meter, which announces the remaining capacity of a rechargeable battery, and a power tool including a battery meter.

Japanese Laid-Open Patent Publication No. 7-192772 describes a method for indicating the remaining capacity of a rechargeable battery. The method includes a process for correcting an estimation error of the remaining capacity of the rechargeable battery when using a large current. To perform the correction, the remaining capacity is calculated from an accumulated value of the discharge current and the battery voltage. When the battery voltage decreases to a set voltage, a correction is made to the remaining capacity that is calculated with the battery voltage.

Japanese Laid-Open Patent Publication No. 2007-139549 describes a method for measuring the remaining capacity of a rechargeable battery. The method includes a remaining capacity computation process performed in correspondence with different situations, namely, before an electrical load is supplied with power (i.e., when power is not supplied), when the electrical load is supplied with power, and after the electrical load is supplied with power.

In the remaining capacity measurement for the rechargeable battery of the above embodiments, the inventors of the present invention have noticed that during usage of the rechargeable battery, the computation result of the remaining capacity deviates greatly from the actual remaining capacity. Thus, for example, when the rechargeable battery is supplying a large current to the electrical load, it would be difficult to accurately estimate the remaining capacity of the rechargeable battery.

In the techniques of the above publications, an electric instrument may indicate that the remaining capacity of the rechargeable battery is low even though the actual remaining capacity is high enough to permit discharging of the rechargeable battery. Such an incorrect indication would prompt the user of the electric instrument to replace the rechargeable battery. On the other hand, an electric instrument may indicate that the remaining capacity of the rechargeable battery is sufficient even though the actual remaining capacity is low such that discharging of the rechargeable battery should be prohibited. Such an incorrect indication would result in the user continuing the use of the electric instrument. This would lead to over-discharging of the rechargeable battery.

JP H07 16364 U describes a treatment cylinder is attached to a fixing member, and a hook 4 is attached to a cover edge. The fixing member is connected to a lifting-up member which lifts up the hook 4 to upright posture. A piston rod of the treatment cylinder is connected to a pusher which pushes and tilts the lifting-up member toward a seat frame, and then pushes the hook toward the seat frame to hook the hook on a retaining rim of the seat frame.

GB 2 426 390 A describes a battery-operated power tool that has a state of charge indicator (or "fuel gauge") to show the 'at rest' state of charge of the battery. The power tool may have a switch assembly to electrically connect the motor to the battery. When the switch assembly is activated the state of charge of the battery may be measured and displayed on the fuel gauge before electrically connecting the motor and the battery, with the display being stopped before the switch is deactivated. The power tool may comprise a movable spindle for supporting a tool element, a housing supporting the motor and a drive mechanism connected to the spindle, a battery connected to the rear of the housing and a fuel gauge for displaying the 'at rest' state of charge of the battery.

JP 4 772205 B2 describes after stopping feeding a main load with power and a further short time lapse, a remaining capacity is indicated for a specified time. The detecting operation of the remaining capacity is conducted in a period from the power feed stop to the remaining capacity indication with an indication showing in operation for detecting the remaining capacity.

US 2003/137303 A1 describes a device for determining a charge condition of an electric storage battery connected to a consumer has a unit for detecting an operational value of the battery from which a charge condition can be derived, the unit being operative for detecting a terminal voltage of the battery and deriving the charge condition exclusively from such voltage values which are applied on output terminals of the battery when a level of current taken from the consumer reaches a predetermined value.

US 2006/197536 A1 describes a method for determining a recovery voltage in a battery includes detecting a transient increased current draw event drawing current from the battery, the transient increased current draw event starting at a start time and ending at an end time; and in response to detecting the transient increased current draw event, waiting until time and/or voltage criteria are met to determine recovered battery voltage. An implantable pulse generator (PG) device for stimulating a human organ includes a battery, a power sink drawing current from the battery, wherein drawing increased current from the battery for transient periods causes battery voltage to decrease; and a status indicator detecting a transient increased current draw event and waiting a minimum time duration after the transient increased current draw event to measure battery voltage in order to determine a recovery voltage.

US 6 437 699 B1 describes when a remaining capacity of a battery is displayed by remaining capacity display control means, operation state discrimination function discriminates an operation state of an apparatus and also discriminates whether battery output voltage is greater than discrimination value when the apparatus is in reception indication operation. If the battery output voltage is greater than the discrimination value, remaining capacity of the battery corresponding to the battery output voltage in a standby state immediately before the start of the reception indication operation is displayed on LCD. If the battery output voltage is equal to or smaller than the discrimination value, the remaining capacity of the battery corresponding to the battery output voltage of this time is displayed as it is on the LCD.It is an object of the present invention to provide a battery meter that obviates or limits the announcement of incorrect remaining capacity information of a rechargeable battery and a power tool including a battery meter.

The invention is defined by independent claim 1. Preferred embodiments are described in the dependent claims. One aspect of the present invention is a tool main body that comprises a battery meter for use with a rechargeable battery that supplies power to an electrical load. The battery meter includes a voltage measurement unit for measuring an inter-terminal voltage of the rechargeable battery, an announcement unit for announcing rechargeable battery remaining capacity information based on the measurement of the inter-terminal voltage, and an announcement request switch for outputting an announcement request for requesting announcement of the remaining capacity information. The announcement unit is configured to announce the remaining capacity information when the announcement request is received during a period in which the electrical load is not supplied with power, and not announce the remaining capacity information regardless of whether or not the announcement request is received during a period in which the electrical load is supplied with power.

Preferably, the announcement unit is configured to generate the remaining capacity information when the announcement request is received during a period in which the electrical load is not supplied with power, and announce the remaining capacity information, which is generated when the announcement request is received, throughout a set announcement period even when the inter-terminal voltage changes after the announcement request is received.

Preferably, the announcement unit includes a recovery prediction function or a recovery prediction map for predicting recovery of the inter-terminal voltage when the supply of power to the electrical load is stopped. Further, the announcement unit is configured to predict a recovered inter-terminal voltage with the recovery prediction function or the recovery prediction map when the supply of power to the electrical load is stopped, and generate the rechargeable battery remaining capacity information based on the prediction of the recovered inter-terminal voltage.

Preferably, when the supply of power to the electrical load is started during an announcement of the rechargeable battery remaining capacity information, the announcement unit interrupts the announcement of the rechargeable battery remaining capacity information.

Preferably, the announcement unit includes an indicator that visually indicates the rechargeable battery remaining capacity information.

Preferably, the announcement unit includes a voice generator that generates a voice to announce the rechargeable battery remaining capacity information.

Preferably, the electrical load is the motor.

A further aspect of the present invention is a power tool including an electrical load and the aforementioned battery meter.

As will be appreciated, other aspects, embodiments, and/or configurations of the disclosure are possible utilizing, alone or in combination, one or more of the features set forth above or described in detail below.

The invention, together with objects and advantages thereof, may best be understood by reference to the following description of the presently preferred embodiments together with the accompanying drawings in which:
Fig. 1 is a perspective view showing one embodiment of a power tool;
Fig. 2 is a block diagram of an electric circuit in the power tool of Fig. 1;
Fig. 3 is a graph showing the relationship of the inter-terminal voltage of the rechargeable battery and the remaining capacity;
Fig. 4 is a table illustrating the announcement of the remaining capacity;
Fig. 5 is a graph illustrating changes in the inter-terminal voltage of the rechargeable battery when the supply of power is started;
Fig. 6 is a graph illustrating changes in the inter-terminal voltage of the rechargeable battery when the supply of power is stopped;
Fig. 7 is a flowchart illustrating a remaining capacity announcement starting process;
Fig. 8 is a flowchart illustrating a remaining capacity announcement stopping process;
Fig. 9 is a timing chart illustrating the period during which the remaining capacity information is indicated;
Fig. 10 is a timing chart illustrating forcible interruption of the indication of the remaining capacity information;
Fig. 11 is a timing chart illustrating the indication of the remaining capacity information in accordance with the inter-terminal voltage of the rechargeable battery; and
Fig. 12 is a diagram illustrating changes in the inter-terminal voltage of the rechargeable battery.

One embodiment of a power tool 1 will now be described.

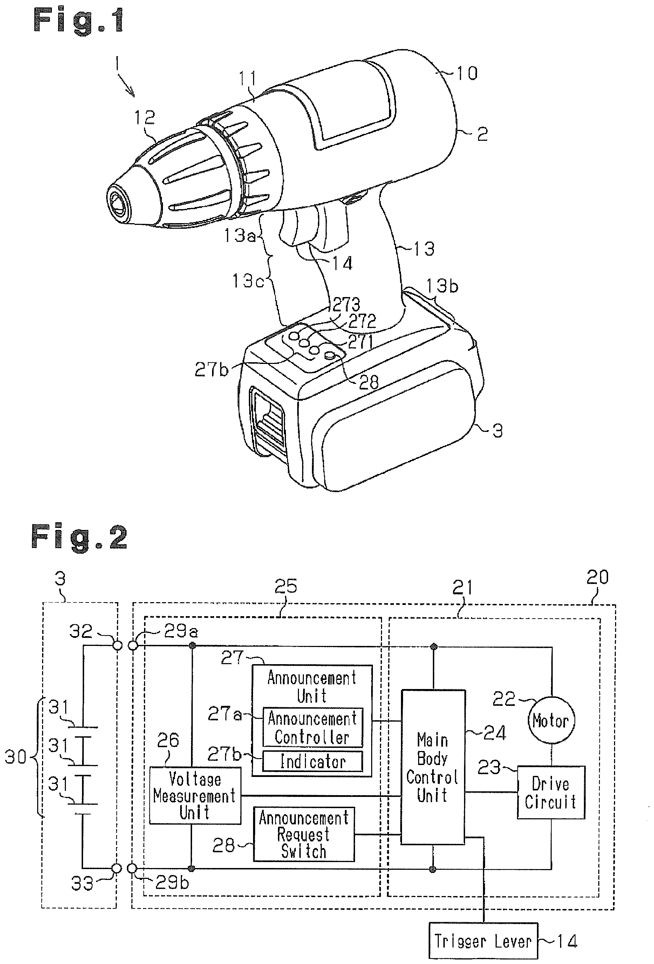

Fig. 1 shows a chargeable drill driver, which is one example of the power tool 1. The power tool 1 includes a tool main body 2 and a battery pack 3, which is attached to the tool main body 2 in a removable manner. The tool main body 2 includes a housing 10 and an electric circuit 20, which is accommodated in the housing 10 (refer to Fig. 2).

The housing 10 includes a barrel 11, a chuck 12, and a grip 13. The electric circuit 20 is accommodated in, for example, the barrel 11. The chuck 12 holds a removable tool bit (e.g., drill).

A trigger lever 14 is coupled to, for example, an upper portion 13a of the grip 13 near the barrel 11.

The trigger lever 14 is used to set the torque applied to the tool bit (e.g., drill). The torque is increased in accordance with the pulled amount of the trigger lever 14. A spring may be used to outwardly urge the trigger lever 14 from the grip 13. The trigger lever 14 is pulled into the grip 13 when operated. The trigger lever 14 outputs a trigger signal Str having a level that is in accordance with the pulled amount. The pulled amount is, for example, the movement distance of the trigger lever 14 when the trigger lever 14 is pulled.

The grip 13 includes a lower portion 13b (side farther from the barrel 11) and a middle portion 13c. The lower portion 13b is wider than the middle portion 13c. The lower portion 13b of the grip 13 includes a lower surface, to which a battery pack 3 is attached in a removable manner, and an upper surface, on which an indicator 27b and an announcement request switch 28 are arranged.

The indicator 27b includes, for example, three light emitting diodes (LEDs), namely, first to third LEDs 271 to 273. In the illustrated example, the first to third LEDs 271 to 273 are arranged in a single line.

The announcement request switch 28 is operated by the user of the power tool 1. The announcement request switch 28 may be, for example, a push button that is moved in a pushing direction to a pushed position when pushed and returned to an original normal position when released.

The battery pack 3 and the electric circuit 20 of the power tool 1 will now be described with reference to Fig. 2.

The battery pack 3 incorporates a rechargeable battery 30. The rechargeable battery 30 may be any rechargeable battery cell, such as a lithium-ion rechargeable battery, a lithium rechargeable battery, or a nickel-metal hydride battery. The battery pack 3, or the rechargeable battery 30, includes a positive electrode 32 and a negative electrode 33 that are configured to be connectable to the electric circuit 20 of the power tool 1. The rechargeable battery 30 includes one or more battery cells 31. In the illustrated example, the battery cells 31 are connected in series.

The electric circuit 20 of the power tool includes a circuit main body 21 and a battery meter 25. The circuit main body 21 includes a motor 22 (electric motor), a drive circuit 23, and a main body control unit 24.

The motor 22 is a driving device that rotates the tool bit (e.g., drill). In comparison with the drive circuit 23 and the main body control unit 24, the motor 22 consumes a large amount of power. The power supplied from the rechargeable battery 30 is mainly consumed by the motor 22. Thus, the motor 22 substantially acts as the main electrical load of the rechargeable battery 30 and is referred to as the electrical load that most dominantly affects the estimation of the remaining capacity C.

The main body control unit 24 receives the trigger signal Str, generates a control signal for controlling the motor 22 in accordance with the level of the trigger signal Str, and provides the control signal to the drive circuit 23. The main body control unit 24, for example, increases the power supplied to the motor 22 as the level of the trigger signal Str increases. When the trigger signal Str is null, the main body control unit 24 supplies the motor 22 with substantially no power. In a non-restrictive example, the control signal may be a pulse width modulation (PWM) signal.

The drive circuit 23 supplies the motor 22 with power that is in accordance with the control signal received from the main body control unit 24.

The main body control unit 24 determines whether or not power is supplied to the motor 22 based on, for example, the level of the trigger signal Str from the trigger lever 14, the amount of current supplied to the motor 22, or the rotation speed of the motor 22. When power is supplied to the motor 22, the main body control unit 24 provides an announcement unit 27 with a power supply determination signal SX indicating that the motor 22 is being supplied with power.

The main body control unit 24 receives an announcement request signal SC from the announcement request switch 28 and transmits the announcement request SC to the announcement unit 27. In a different example, the announcement request switch 28 directly provides the announcement request SC to the announcement unit 27 and does not transmit the announcement request SC via the main body control unit 24.

The battery meter 25 will now be described. The battery meter 25 includes a voltage measurement unit 26, the announcement unit 27, and the announcement request switch 28.

The voltage measurement unit 26 measures the potential difference between a positive terminal 29a and a negative terminal 29b of the electric circuit 20 and provides the main body control unit 24 with a measurement signal indicating the potential difference. The potential difference between the positive terminal 29a and the negative terminal 29b corresponds to the inter-terminal voltage Vt of the rechargeable battery 30. The positive terminal 29a is connected to the positive electrode 32 of the battery pack 3, or the rechargeable battery 30. The negative terminal 29b is connected to the negative electrode 33 of the battery pack 3, or the rechargeable battery 30.

Referring to Fig. 1, the announcement request switch 28 is operated by the user of the power tool 1. When operated, the announcement request switch 28 sends an announcement request SC to the announcement unit 27 to request the announcement unit 27 to announce information related to the rechargeable battery remaining capacity C (hereinafter, referred to as the remaining capacity information). For example, the announcement request switch 28 provides the main body control unit 24 with the announcement request SC when pushed and does not output the announcement request SC when not pushed (normal condition).

The announcement unit 27 includes an announcement controller 27a and the indicator 27b. Based on the announcement request SC and the power supply determination signal SX, the announcement controller 27a determines whether or not to indicate the remaining capacity information of the rechargeable battery 30 with the indicator 27b. When determining to announce the remaining capacity information of the rechargeable battery 30, the announcement controller 27a indicates the remaining capacity information on the indicator 27b.

In accordance with the determination result of the announcement controller 27a, the indicator 27b indicates the remaining capacity information. The announcement controller 27a controls the lighting of the first to third LEDs 271 to 273. For example, the announcement controller 27a activates or deactivates each of the first to third LEDs 271 to 273 in accordance with the rechargeable battery remaining capacity C.

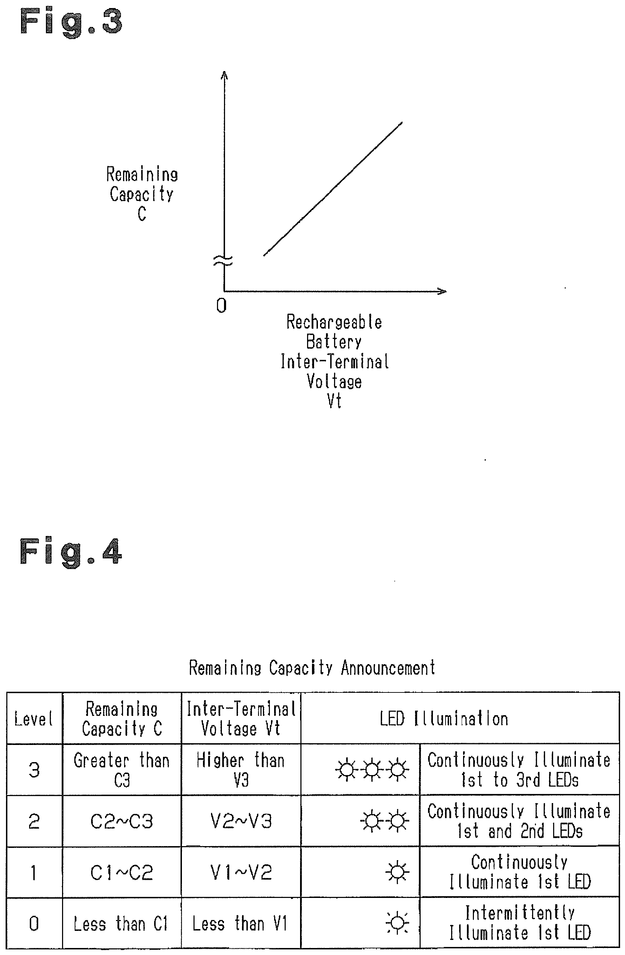

The indication of the rechargeable battery remaining capacity C will now be described with reference to Figs. 3 and 4. Fig. 3 shows the relationship of the inter-terminal voltage V of the rechargeable battery 30 and the rechargeable battery remaining capacity C when the discharge current of the rechargeable battery 30 is substantially zero. The rechargeable battery remaining capacity C decrease as the inter-terminal voltage Vt of the rechargeable battery 30 decreases. This allows the main body control unit 24 to estimate the rechargeable battery remaining capacity C based on the inter-terminal voltage Vt of the rechargeable battery 30.

Fig. 4 is a table showing an indication example of the rechargeable battery remaining capacity C.

When the inter-terminal voltage Vt of the rechargeable battery 30 is lower than voltage V1, the rechargeable battery remaining capacity C is less than capacity C1 (level 0). In this case, the first LED 271 is intermittently illuminated.

When the inter-terminal voltage Vt of the rechargeable battery 30 is higher than or equal to voltage V1 and less than voltage V2, the rechargeable battery remaining capacity C is greater than or equal to capacity C1 and less than capacity C2 (level 1). In this case, the first LED 271 is continuously illuminated.

When the inter-terminal voltage Vt of the rechargeable battery 30 is higher than or equal to voltage V2 and less than voltage V3, the rechargeable battery remaining capacity C is greater than or equal to capacity C2 and less than capacity C3 (level 2). In this case, the first and second LEDs 271 and 272 are continuously illuminated.

When the inter-terminal voltage Vt of the rechargeable battery 30 is higher than or equal to voltage V3, the rechargeable battery remaining capacity C is greater than or equal to capacity C3 (level 3). In this case, the first to third LEDs 271 to 273 are continuously illuminated.

Changes in the inter-terminal voltage Vt of the rechargeable battery 30 will now be described.

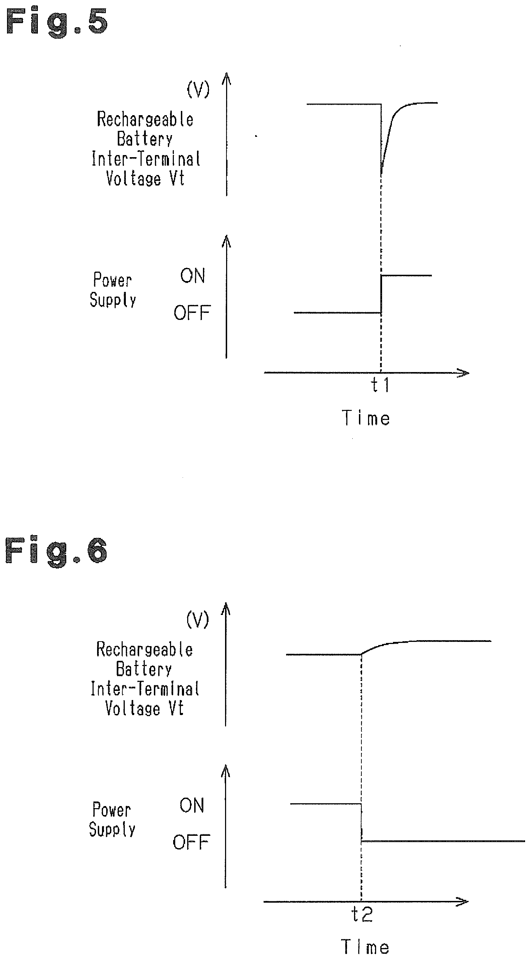

Fig. 5 shows changes in the inter-terminal voltage Vt of the rechargeable battery 30 when the supply of power to the motor 22 is started. At time t1, the user operates the trigger lever 14 to start the supply of power to the motor 22. Due to relatively large inrush current, the inter-terminal voltage Vt of the rechargeable battery 30 decreases temporarily and rapidly increases to show an extreme drop. Thereafter, the inter-terminal voltage Vt of the rechargeable battery 30 gradually and slightly increases as power is continuously consumed by the motor 22 .

Fig. 6 shows changes in the inter-terminal voltage Vt of the rechargeable battery 30 when the supply of power to the motor 22 is stopped. At time t2, the user releases the trigger lever 14 and stops the supply of power to the motor 22. This gradually and slightly increases the inter-terminal voltage Vt of the rechargeable battery 30. The slight voltage increase occurs because the discharge current is large when the motor 22 operates, the voltage drop caused by the internal resistance of the rechargeable battery 30 is large, and the estimated or measured inter-terminal voltage Vt (measured value) is lower than the inter-terminal voltage (true value) corresponding to the actuator remaining capacity Cr.

A problem that arises when indicating the rechargeable battery remaining capacity C based on the inter-terminal voltage Vt of the rechargeable battery 30 will now be described.

When the motor 22 consumes a large amount of motor 22, that is, when the discharge current of the rechargeable battery 30 is large, the inter-terminal voltage (measured value) of the rechargeable battery 30 during operation of the motor 22 is lower than the inter-terminal voltage (true value) corresponding to the actual rechargeable battery remaining capacity Cr. Further, the voltage difference between the inter-terminal voltage Vt (measured value) of the rechargeable battery 30 during operation of the motor 22 and the inter-terminal voltage (true value) corresponding to the actual rechargeable battery remaining capacity Cr is large such that it cannot be ignored when estimating the rechargeable battery remaining capacity C. Thus, when estimating the rechargeable battery remaining capacity C based on the inter-terminal voltage Vt of the rechargeable battery 30 measured during operation of the motor 22, the estimated value would be lower than the actual rechargeable battery remaining capacity Cr. The low estimated value would lead to the following problem during usage of the power tool 1.

For example, if the user checks the rechargeable battery remaining capacity C when operating the power tool 1 and the rechargeable battery remaining capacity C is low, the user would replace the battery pack 3 with another battery pack. However, the rechargeable battery remaining capacity C when the power tool 1 is operating is indicated as being lower than the actual rechargeable battery remaining capacity Cr. Thus, the user would be replacing the battery pack 3 based on an incorrect estimation result of the rechargeable battery remaining capacity. When the rechargeable battery remaining capacity C is indicated during operation of the power tool 1, the battery pack 3 may be replaced even though the battery pack 3 can still be used. In this manner, even though the battery pack 3 is still usable, the user would replace the battery pack 3. This increases the number of times the battery pack 3 is replaced. Further, the user would erroneously believe that the power loss is large in the power tool 1, and the frequent battery pack replacement would be inconvenient for the user.

In this regard, the power tool 1 of the present embodiment performs a process that stops the indication of the rechargeable battery remaining capacity C when the motor 22 is operating. One example of the process will now be described.

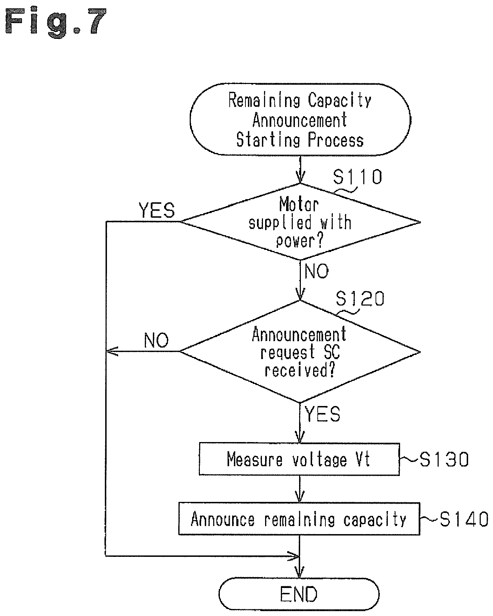

A process for starting a remaining capacity announcement will now be described with reference to Fig. 7. The announcement unit 27 performs the remaining capacity announcement starting process in predetermined cycles.

In step S110, the announcement controller 27a determines whether or not the motor 22 is being supplied with power. The determination is based on the power supply determination signal SX from the main body control unit 24. For example, when receiving the power supply determination signal SX, the announcement controller 27a determines that the motor 22 is being supplied with power. When the power supply determination signal SX is not received, the announcement controller 27a determines that the motor 22 is not being supplied with power.

When the motor 22 is being supplied with power (YES in step S110), the announcement controller 27a ends the remaining capacity announcement starting process.

When the motor 22 is not being supplied with power (NO in step S 110), in step S120, the announcement controller 27a determines whether or not the announcement request SC has been received.

When the announcement request SC has not been received (NO in step S120), the announcement controller 27a ends the remaining capacity announcement starting process.

When the announcement request SC has been received (YES in step S120), in step S130, the announcement controller 27a measures the inter-terminal voltage Vt of the rechargeable battery 30.

In step S140, the announcement controller 27a generates the remaining capacity information based on the measured inter-terminal voltage Vt and announces the remaining capacity information. The remaining capacity information indicates the level of the rechargeable battery remaining capacity C. The remaining capacity information is indicated based on the level of the rechargeable battery remaining capacity C shown in the row at the left end of Fig. 4.

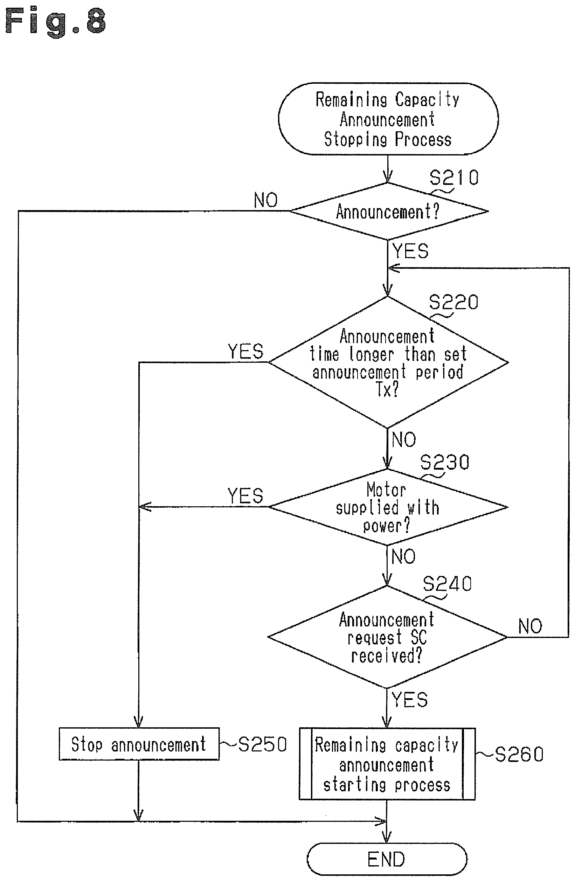

A process for stopping the remaining capacity announcement will now be described with reference to Fig. 8. The announcement unit 27 performs the remaining capacity announcement stopping process while announcing the rechargeable battery remaining capacity C.

In step S210, the announcement unit 27 determines whether or not the remaining capacity information is being announced. When the remaining capacity information is not being announced (NO in step S210), the announcement unit 27 ends the remaining capacity announcement stopping process. The announcement unit 27 may be configured not to perform the remaining capacity announcement stopping process when the remaining capacity information is not being announced.

When the remaining capacity information is being announced (YES in step S210), in step S220, the announcement unit 27 determines whether or not the announcement time of the remaining capacity information is longer than a predetermined set announcement period Tx. The set announcement period Tx is set to be long enough to allow the user to acknowledge the remaining capacity information.

When the announcement time of the remaining capacity information is longer than the set announcement period Tx (YES in step S220), the remaining capacity information should have been acknowledged by the user. Thus, the announcement unit 27 stops the announcement of the remaining capacity information. Under normal situations, the remaining capacity information is announced throughout the set announcement period Tx.

Even if the inter-terminal voltage Vt of the rechargeable battery 30 changes during the announcement of the remaining capacity information, the remaining capacity information, which is set during step S 140 during the remaining capacity announcement starting process, is continuously announced without being changed until the set announcement period Tx ends or an announcement stopping command is received.

When the announcement time of the remaining capacity information is shorter than or equal to the set announcement period Tx (NO in step S220), in step S230, the announcement unit 27 determines whether or not power is being supplied to the motor 22. For example, when the power supply determination signal SX is received from the main body control unit 24, the announcement controller 27a determines that the motor 22 is being supplied with power.

When the motor 22 is being supplied with power (YES in step S230), in step S250, the announcement unit 27 stops the announcement of the remaining capacity information. As described above, the announcement is stopped because the estimation accuracy of the rechargeable battery remaining capacity C, which is based on the inter-terminal voltage Vt, is low when power is being supplied to the motor 22.

When the motor 22 is not being supplied with power (NO in step S230), in step S240, the announcement unit 27 determines whether or not an announcement request SC has been received.

When an announcement request SC has not been received (NO in step S240), the announcement unit 27 returns to step S220.

When an announcement request SC has been received (YES in step S240), in step S260, the announcement unit 27 performs the remaining capacity announcement starting process. When he remaining capacity announcement starting process is started, the previous announcement time and the previous remaining capacity information are reset or initialized, and the announcement time and the inter-terminal voltage Vt are measured from the beginning. When the remaining capacity announcement starting process is performed, the remaining capacity announcement stopping process is terminated.

For example, the announcement of the remaining capacity information is continued throughout the set announcement period Tx. However, when the motor 22 is supplied with power during the announcement of the remaining capacity information, the announcement is interrupted. When a new announcement request SC is received during the announcement of the remaining capacity information, the remaining capacity announcement starting process is performed as long as the motor 22 is not supplied with power.

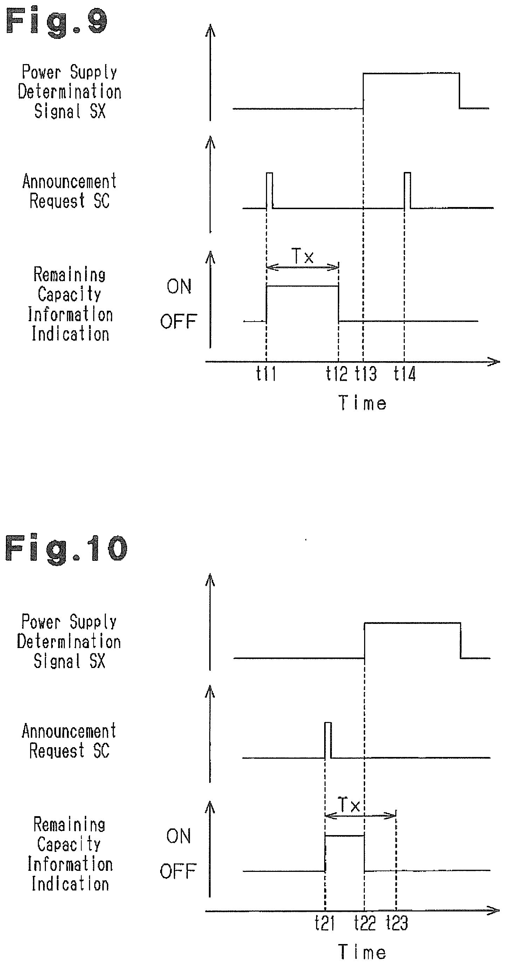

The operation of the battery meter 25 will now be described with reference to Figs. 9 to 11.

Time t11 in Fig. 9 indicates the timing in which the announcement unit 27 receives the announcement request SC when the motor 22 is not being supplied with power. At time t11, the remaining capacity announcement starting process indicates the remaining capacity information of the rechargeable battery 30 with the indicator 27b. For example, when the inter-terminal voltage Vt of the rechargeable battery 30 is higher than or equal to voltage V3, the first to third LEDs 271 to 273 are continuously illuminated. The remaining capacity information is indicated during the period from time t11 to time t12, which is when the set announcement period Tx ends.

At time 113, the supply of power to the motor 22 starts. At time t14, the announcement unit 27 receives an announcement request SC when the motor 22 is being supplied with power. In this case, since the motor 22 is being supplied with power, due to the remaining capacity announcement starting process, the indicator 27b does not indicate the remaining capacity information of the rechargeable battery 30 even though the announcement request SC has been received. Accordingly, the first to third LEDs 271 to 273 remain deactivated.

The processing performed when the remaining capacity information of the rechargeable battery 30 is being indicated as the supply of power to the motor 22 starts will now be described with reference to Fig. 10.

At time t21, which is before power is supplied to the motor 22, the announcement unit 27 receives an announcement request SC. Thus, at time t21, the remaining capacity announcement starting process indicates the remaining capacity information of the rechargeable battery 30 with the indicator 27b.

At time t22, the supply of power to the motor 22 is started. Time t22 is before the set announcement period Tx ends, or before t23. However, the determination of step S230 in the remaining capacity announcement stopping process interrupts the indication of the remaining capacity information. In this manner, when the motor 22 is supplied with power, the remaining capacity information of the rechargeable battery 30 is not indicated.

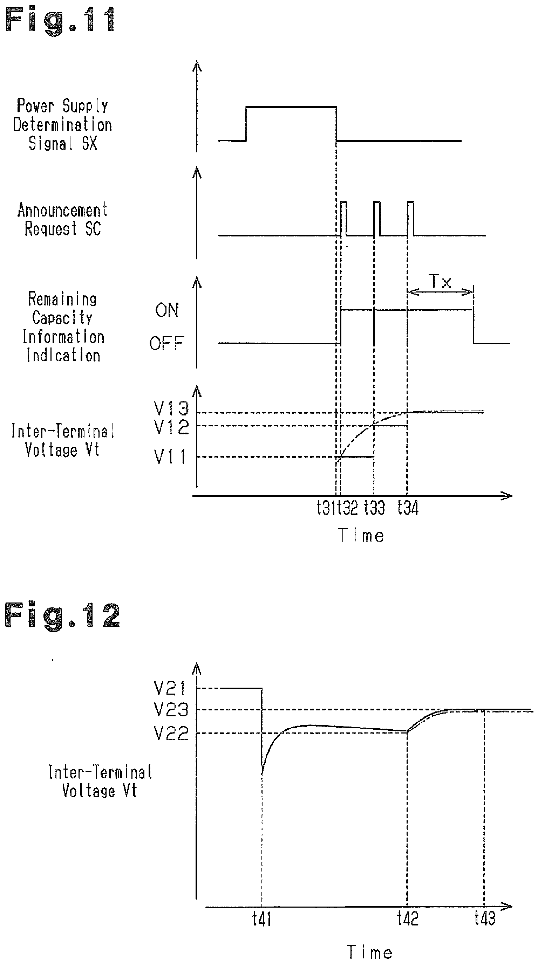

The processing performed when the announcement request switch 28 is successively pushed immediately after the supply of power to the motor 22 stops will now be described. The double-dashed line in Fig. 11 show changes in the inter-terminal voltage Vt of the rechargeable battery 30.

At time t31, the supply of power to the motor 22 is stopped. At each of times t32, t33, and t34, the announcement request switch 28 is pushed, and the announcement request SC is provided to the announcement unit 27. In Fig. 11, the period between time t32 and time t33 and the period between time t33 and time t34 are shorter than the set announcement period Tx. Thus, while the remaining capacity information generated at time t31 is being announced, the announcement unit 27 starts announcing the remaining capacity information that is newly generated at time t32. Then, while the remaining capacity information generated at time t32 is being announced, the announcement unit 27 starts announcing the remaining capacity information that is newly generated at time t33.

When the supply of power to the motor 22 is stopped, the inter-terminal voltage Vt of the rechargeable battery 30 may gradually increase. Thus, the remaining capacity information indicated by the indicator 27b is updated at time t32, time t33, and time t34.

For example, as shown in Fig. 11, the inter-terminal voltage Vt measured at time t32, time t33, and time t34 may be voltage V11, voltage V12, and voltage V13, respectively. Further, voltage V11 and voltage V12 may be between voltage V2 and voltage V3 in the table of Fig. 4, and voltage V13 may be higher than or equal to voltage V3 in the table of Fig. 4. In this case, the indicator 27b continuously illuminates two LEDs, namely, the first LED 271 and the second LED 272. Then, the indicator 27b continuously illuminates three LEDs, namely, the first LED 271, the second LED 272, and the third LED 273.

The advantages of the present embodiment will now be described.
(1) The battery meter 25 includes the announcement unit 27. As shown in Fig. 9, the announcement unit 27 announces the remaining capacity information when receiving the announcement request SC as long as power is not being supplied to the motor 22. However, when power is being supplied to the motor 22, the announcement unit 27 does not announce the remaining capacity information regardless of whether or not the announcement request SC is received.

The inter-voltage Vt of the rechargeable battery 30 when power is being supplied to the motor 22 is lower than the actual inter-terminal voltage of the rechargeable battery 30, that is, the inter-terminal voltage Vt when discharging is not performed. Thus, when power is being supplied to the motor 22, the remaining capacity information is not announced regardless of whether or not the announcement request SC is received. This obviates or limits the announcement of incorrect remaining capacity information of the rechargeable battery 30 to the user.

(2) In the present embodiment, as shown in Fig. 11, when the announcement unit 27 announces the remaining capacity information, the announcement unit 27 announces the remaining capacity information generated when the announcement request SC is received without changing the remaining capacity information throughout the set announcement period Tx.

This allows for stable announcement of the remaining capacity information.

If the remaining capacity information were to be changed in accordance with changes in the inter-terminal voltage of the rechargeable battery 30, the information indicated by the indicator 27b would be frequently changed. For example, when the inter-terminal voltage Vt increases and decreases around voltage V2, which is shown in Fig. 4, the indication of the indicator 27b would be frequently changed. This would result in the user erroneously determining that the rechargeable battery 30 is unstable. Thus, by stabilizing the indication of the remaining capacity information, the user would not erroneously determine that the rechargeable battery 30 is unstable.

(3) In the present embodiment, as shown in Fig. 10, if the announcement unit 27 receives a signal indicating that power is being supplied to the motor 22 when announcing the remaining capacity information of the rechargeable battery 30, the announcement unit 27 stops announcing the remaining capacity information of the rechargeable battery 30.

For example, when the supply of power to the motor 22 is started, the rechargeable battery remaining capacity C starts to decrease. Thus, if the remaining capacity information of the rechargeable battery 30 were to be continuously announced when the supply of power to the motor 22 starts, incorrect remaining capacity information of the rechargeable battery 30 would be announced to the user. In the above embodiment, if the supply of power to the motor 22 starts when the remaining capacity information of the rechargeable battery 30 is being announced, the announcement is stopped. This obviates or limits the announcement of such incorrect remaining capacity information.

(4) In the present embodiment, the announcement unit 27 includes the indicator 27b, which indicates the remaining capacity information of the rechargeable battery 30. This allows for the user to view the remaining capacity information of the rechargeable battery 30.

(5) In the present embodiment, the main electrical load of the rechargeable battery 30 is the motor 22. The motor 22 consumes a large amount of power, and changes are large in the amount of the consumed current. Due to the voltage drops in the internal resistance of the rechargeable battery 30 that cannot be ignored, the rechargeable battery remaining capacity C estimated when the motor 22 is being driven easily becomes incorrect. Thus, by applying the battery meter 25 of the present embodiment to the electric circuit 20 including the motor 22, the announcement of incorrect remaining capacity information of the rechargeable battery 30 may be obviated or limited.

(6) The power tool 1 of the present embodiment includes the battery meter 25. This allows for the announcement of incorrect remaining capacity information of the rechargeable battery 30 to be obviated or limited.

In the above embodiment, whenever the remaining capacity announcement starting process is executed, the inter-terminal voltage Vt of the rechargeable battery 30 is measured, and the remaining capacity information based on the inter-terminal voltage Vt is indicated by the indicator 27b. Thus, as shown in Fig. 11, during the period the inter-terminal Vt recovers immediately after the supply of power to the motor 22 is stopped, the indication of the indicator 27b would change if the announcement request switch 28 were to be pushed a number of times. Although the announcement request switch 28 would be seldom pushed a number of times during the period the inter-terminal voltage Vt recovers, such changes in the indication of the indicator 27b may result in the user determining that the rechargeable battery remaining capacity C is increasing. Thus, it is preferable that changes be decreased in the indication of the indicator 27b when the rechargeable battery remaining capacity C increases. Accordingly, during the recovery of the inter-terminal voltage Vt immediately after the supply of power to the motor 22 stops, the recovered inter-terminal voltage Vt may be predicted, and the remaining capacity information may be announced based on the prediction.

For example, the announcement unit 27 may be configured to include a recovery prediction function (double-dashed line in Fig. 12) for predicting the recovered inter-terminal voltage Vt. The recovery prediction function is set through discharge tests or the like conducted on the rechargeable battery 30. Further, the recovery prediction function is configured to calculate the inter-terminal voltage Vt after a predetermined period by inputting an initial inter-terminal voltage Vt.

The operation of the announcement unit 27 will now be described with reference to Fig. 12.

Fig. 12 is a chart for predicting the recovered inter-terminal voltage Vt immediately after the supply of power to the motor 22 is stopped.

When predicting the recovered inter-terminal voltage Vt, the inter-terminal voltage Vt is measured immediately after the supply of power to the motor 22 is stopped, and the voltage V22 obtained through the measurement is input as an initial value to the recovery prediction function. Further, the terminal voltage Vt after a predetermined time (i.e., time t43), which is voltage V23, is predicted. In the prediction, the predicted inter-terminal voltage Vt may be corrected based on the inter-terminal voltage Vt immediately before the supply of power to the motor 22 is started (voltage V21 at time t41). Further, the amount of current supplied to the motor 22 may be accumulated during the period from when the supply of power to the motor 22 starts (time t41) to when the supply of power stops (time t42), and the predicted inter-terminal voltage Vt may be corrected based on the accumulated value.

In this example, when the supply of power to the motor 22 is stopped, the recovered inter-terminal voltage Vt after the supply of power to the motor 22 is stopped is predicted using the recovery prediction function. Then, the remaining capacity information of the rechargeable battery 30 is generated based on the predicted inter-terminal voltage Vt.

More specifically, when the announcement request switch 28 is pushed immediately after the supply of power to the motor 22 is stopped, the remaining capacity information that is announced is estimated from the predicted inter-terminal voltage Vt. Thus, the remaining capacity information is stably indicated by the indicator 27b. This obviates or limits the user erroneously determining that the rechargeable battery remaining capacity C is increasing.

In the above example, a recovery prediction function is used to predict the recovered inter-terminal voltage Vt when the inter-terminal voltage recovers immediately after the supply of power to the motor 22 stops. However, a recovery prediction may be used in lieu of the recovery prediction function. The recovery prediction map, for example, associates the inter-terminal voltage Vt immediately after the supply of power to the motor 22 stops with the recovered inter-terminal voltage Vt after a predetermined period.

In the above embodiment, the determination of whether or not the motor 22 is supplied with power is performed based on the power supply determination signal SX output from the main body control unit 24. In other words, the main body control unit 24 substantially determines whether or not power is being supplied to the motor 22. However, the announcement unit 27 may determine whether or not power is being supplied to the motor 22.

In the above embodiment, the indicator 27b visually indicates and announces the remaining capacity information of the rechargeable battery 30 so that the user may check the remaining capacity information of the rechargeable battery 30. However, the means for announcing the remaining capacity information of the rechargeable battery 30 is not limited in such a manner. For example, a voice may be generated to announce the remaining capacity information of the rechargeable battery 30. In this case, the power tool 1 is provided with a voice generator formed by a speaker or the like instead of the indicator 27b. Alternatively, the indicator 27b and the voice generator may both be provided in the power tool. In such cases, a voice is generated to announce the remaining capacity information of the rechargeable battery 30 to the user.

In the above embodiment, the announcement unit 27 is located outside the main body control unit 24 but may be located inside the main body control unit 24.

In the above embodiment, the voltage measurement unit 26 is located outside the announcement unit 27 but may be located inside the voltage measurement unit 26.

The power tool 1 is not limited to a chargeable drill driver and may be, for example, a chargeable saw, a chargeable air pump, a chargeable cutter, a chargeable blower, and a chargeable chain saw.

In the above embodiment, the battery meter 25 is applied to the electric circuit 20 including the motor 22 but may be applied to an electric circuit 20 including an electrical load other than the motor 22. For example, the electrical load may be an electric heating device (nichrome wire, heating coil, or the like).

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although embodiments of the present invention have been described in detail, it should be understood that various changes, substitutions, and alterations could be made hereto within the scope of the claimed invention, which is defined by the appended claims.

## Claims

1. A tool main body (2) comprising an electrical load (22), the tool main body (2) comprising a battery meter (25) for use with a rechargeable battery (30) configured to supply power to the electrical load (22), the battery meter (25) comprising:
a voltage measurement unit (26) for measuring an inter-terminal voltage (Vt) of the rechargeable battery (30);
an announcement unit (27) for announcing rechargeable battery remaining capacity information based on the measurement of the inter-terminal voltage (Vt); and
an announcement request switch (28) for outputting an announcement request (SC) for requesting announcement of the remaining capacity information, wherein:
the announcement unit (27) is configured to
announce the remaining capacity information when the announcement request (SC) is received during a period in which the electrical load (22) is not supplied with power, and
wherein the tool main body (2) is **characterized in that**
the announcement unit (27) is configured to
not announce the remaining capacity information regardless of whether or not the announcement request (SC) is received during a period in which the electrical load (22) is supplied with power,
wherein the tool main body (2) is further configured such that,
during a period in which the electrical load (22) is not supplied with power, at each of times (t32, t33) when the announcement request switch (28) is pushed, the announcement request (SC) is provided to the announcement unit (27) and the remaining capacity information is updated at each of the times even if a period between two times when the announcement request switch (28) is pushed is shorter than a set announcement period (Tx).

2. The tool main body (2) provided with the battery meter (25) according to claim 1, being **characterized in that** the announcement unit (27) is configured to
generate the remaining capacity information when the announcement request (SC) is received during a period in which the electrical load (22) is not supplied with power (S130), and
announce the remaining capacity information, which is generated when the announcement request (SC) is received, throughout the set announcement period (Tx) even when the inter-terminal voltage (Vt) changes after the announcement request (SC) is received.

3. The tool main body (2) provided with the battery meter (25) according to claim 1 or 2, being **characterized in that**:
the announcement unit (27) includes a recovery prediction function or a recovery prediction map for predicting recovery of the inter-terminal voltage (Vt) when the supply of power to the electrical load (22) is stopped; and
the announcement unit (27) is configured to
predict a recovered inter-terminal voltage (Vt) with the recovery prediction function or the recovery prediction map when the supply of power to the electrical load (22) is stopped, and
generate the rechargeable battery remaining capacity information based on the prediction of the recovered inter-terminal voltage (Vt).

4. The tool main body (2) provided with the battery meter (25) according to any one of claims 1 to 3, being **characterized in that** the tool main body (2) is configured such that, when the supply of power to the electrical load (22) is started (t22) during an announcement of the rechargeable battery remaining capacity information, the announcement unit (27) interrupts the announcement of the rechargeable battery remaining capacity information.

5. The tool main body (2) provided with the battery meter (25) according to any one of claims 1 to 4, being **characterized in that** the announcement unit (27) includes an indicator (27b) that visually indicates the rechargeable battery remaining capacity information.

6. The tool main body (2) provided with the battery meter (25) according to any one of claims 1 to 5, being **characterized in that** the announcement unit (27) includes a voice generator that generates a voice to announce the rechargeable battery remaining capacity information.

7. The tool main body (2) provided with the battery meter (25) according to any one of claims 1 to 6, being **characterized in that** the electrical load (22) is a motor (22).

8. A power tool (1) being **characterized by**:
the tool main body (2) provided with the battery meter (25) according to any one of claims 1 to 7.

## Patentansprüche

1. Werkzeuggrundkörper (2), eine elektrischen Last (22) aufweisend, wobei der Werkzeuggrundkörper (2) ein Batteriemessgerät (25) zur Verwendung mit einer wiederaufladbaren Batterie (30) aufweist, die konfiguriert ist, um die elektrische Last (22) mit Strom zu versorgen, wobei das Batteriemessgerät (25) aufweist:
eine Spannungsmesseinheit (26) zum Messen einer Zwischenkreisspannung (Vt) der wiederaufladbaren Batterie (30) ;
eine Ansageeinheit (27) zum Ansagen von Restkapazitätsinformationen der wiederaufladbaren Batterie auf der Grundlage der Messung der Zwischenkreisspannung (Vt); und
einen Ansageanforderungsschalter (28) zum Ausgeben einer Ansageanforderung (SC) zum Anfordern einer Ansage der Restkapazitätsinformationen, wobei:
die Ansageeinheit (27) konfiguriert ist, um
die Restkapazitätsinformationen anzusagen, wenn die Ansageanforderung (SC) während eines Zeitraums empfangen wird, in dem die elektrische Last (22) nicht mit Strom versorgt wird, und
wobei der Werkzeuggrundkörper (2) **dadurch gekennzeichnet ist, dass**
die Ansageeinheit (27) konfiguriert ist, um die Restkapazitätsinformationen nicht anzusagen, unabhängig davon, ob die Ansageanforderung (SC) während eines Zeitraums empfangen wird, in dem die elektrische Last (22) mit Strom versorgt wird oder nicht,
wobei der Werkzeuggrundkörper (2) ferner so konfiguriert ist, dass
während eines Zeitraums, in dem die elektrische Last (22) nicht mit Strom versorgt wird, zu jeder der Zeiten (t32, t33), zu denen der Ansageanforderungsschalter (28) gedrückt wird, die Ansageanforderung (SC) der Ansageeinheit (27) vorgesehen wird und die Restkapazitätsinformationen zu jeder der Zeiten aktualisiert werden, selbst wenn ein Zeitraum zwischen zwei Zeiten, zu denen der Ansageanforderungsschalter (28) gedrückt wird, kürzer als ein eingestellter Ansagezeitraum (Tx) ist.

2. Werkzeuggrundkörper (2), der mit dem Batteriemessgerät (25) nach Anspruch 1 versehen ist, **dadurch gekennzeichnet, dass** die Ansageeinheit (27) konfiguriert ist, um
die Restkapazitätsinformationen zu erzeugen, wenn die Ansageanforderung (SC) während eines Zeitraums empfangen wird, in dem die elektrische Last (22) nicht mit Strom versorgt wird (S130), und
die Restkapazitätsinformationen, die erzeugt werden, wenn die Ansageanforderung (SC) empfangen wird, während des gesamten eingestellten Ansagezeitraums (Tx) anzusagen, selbst wenn sich die Zwischenkreisspannung (Vt) ändert, nachdem die Ansageanforderung (SC) empfangen wurde.

3. Werkzeuggrundkörper (2), der mit dem Batteriemessgerät (25) nach Anspruch 1 oder 2 versehen ist, **dadurch gekennzeichnet, dass**:
die Ansageeinheit (27) eine Wiederherstellungsvorhersagefunktion oder eine Wiederherstellungsvorhersagekarte zum Vorhersagen der Wiederherstellung der Zwischenkreisspannung (Vt), wenn die Stromversorgung der elektrischen Last (22) angehalten ist, enthält; und
die Ansageeinheit (27) konfiguriert ist, um
eine wiederhergestellte Zwischenkreisspannung (Vt) mit der Wiederherstellungsvorhersagefunktion oder der Wiederherstellungsvorhersagekarte vorherzusagen, wenn die Stromversorgung der elektrischen Last (22) angehalten ist, und
die Restkapazitätsinformationen der wiederaufladbaren Batterie auf der Grundlage der Vorhersage der wiederhergestellten Zwischenkreisspannung (Vt) zu erzeugen.

4. Werkzeuggrundkörper (2), der mit dem Batteriemessgerät (25) nach einem der Ansprüche 1 bis 3 versehen ist, **dadurch gekennzeichnet, dass** der Werkzeuggrundkörper (2) so konfiguriert ist, dass die Ansageeinheit (27) die Ansage der Restkapazitätsinformationen der wiederaufladbaren Batterie unterbricht, wenn die Stromversorgung der elektrischen Last (22) während einer Ansage der Restkapazitätsinformationen der wiederaufladbaren Batterie gestartet wird (t22).

5. Werkzeuggrundkörper (2), der mit dem Batteriemessgerät (25) nach einem der Ansprüche 1 bis 4 versehen ist, **dadurch gekennzeichnet, dass** die Ansageeinheit (27) eine Anzeige (27b) enthält, die die Restkapazitätsinformationen der wiederaufladbaren Batterie visuell anzeigt.

6. Werkzeuggrundkörper (2), der mit dem Batteriemessgerät (25) nach einem der Ansprüche 1 bis 5 versehen ist, **dadurch gekennzeichnet, dass** die Ansageeinheit (27) einen Sprachgenerator enthält, der eine Stimme erzeugt, um die Restkapazitätsinformationen der wiederaufladbaren Batterie anzusagen.

7. Werkzeuggrundkörper (2), der mit dem Batteriemessgerät (25) nach einem der Ansprüche 1 bis 6 versehen ist, **dadurch gekennzeichnet, dass** die elektrische Last (22) ein Motor (22) ist.

8. Motorbetriebenes Werkzeug (1), **gekennzeichnet durch**:
den Werkzeuggrundkörper (2), der mit dem Batteriemessgerät (25) nach einem der Ansprüche 1 bis 7 versehen ist.

## Revendications

1. Corps principal d'outil (2) comprenant une charge électrique (22), le corps principal d'outil (2) comprenant un compteur de batterie (25) destiné à être utilisé avec une batterie rechargeable (30) configurée pour fournir de l'énergie à la charge électrique (22), le compteur de batterie (25) comprenant :
une unité de mesure de la tension (26) destinée à mesurer une tension inter-bornes (Vt) de la batterie rechargeable (30) ;
une unité d'annonce (27) destinée à annoncer des informations sur la capacité restante de la batterie rechargeable sur la base de la mesure de la tension inter-bornes (Vt) ; et
un bouton de demande d'annonce (28) destiné à déclencher une demande d'annonce (SC) afin de demander l'annonce des informations sur la capacité restante, dans lequel :
l'unité d'annonce (27) est configurée pour
annoncer les informations sur la capacité restante lorsque la demande d'annonce (SC) est reçue pendant une période au cours de laquelle la charge électrique (22) n'est pas alimentée en énergie, et
dans lequel le corps principal d'outil (2) est **caractérisé en ce que** l'unité d'annonce (27) est configurée pour
ne pas annoncer les informations sur la capacité restante, que la demande d'annonce (SC) soit reçue ou non pendant une période au cours de laquelle la charge électrique (22) est alimentée en énergie,
dans lequel le corps principal d'outil (2) est en outre configuré de sorte que,
pendant une période au cours de laquelle la charge électrique (22) n'est pas alimentée en énergie, au chacun des moments (t32, t33) auxquels le bouton de demande d'annonce (28) est enfoncé, la demande d'annonce (SC) soit fournie à l'unité d'annonce (27) et les informations sur la capacité restante soient mises à jour à chacun des moments même si une période entre deux moments auxquels le bouton de demande d'annonce (28) a été enfoncé est plus courte qu'une période d'annonce définie (Tx).

2. Corps principal d'outil (2) équipé du compteur de batterie (25) selon la revendication 1, **caractérisé en ce que** l'unité d'annonce (27) est configurée pour
générer les informations sur la capacité restante lorsque la demande d'annonce (SC) est reçue pendant une période au cours de laquelle la charge électrique (22) n'est pas alimentée en énergie (S130), et
annoncer les informations sur la capacité restante, qui sont générées lorsque la demande d'annonce (SC) est reçue, au cours de la période d'annonce définie (Tx) même lorsque la tension inter-bornes (Vt) change après que la demande d'annonce (SC) a été reçue.

3. Corps principal d'outil (2) équipé du compteur de batterie (25) selon la revendication 1 ou 2, **caractérisé en ce que** :
l'unité d'annonce (27) comprend une fonction de prédiction de récupération ou une carte de prédiction de récupération destinée à prédire la récupération de la tension inter-bornes (Vt) lorsque l'alimentation en énergie de la charge électrique (22) est arrêtée ; et
l'unité d'annonce (27) est configurée pour
prédire une tension inter-bornes récupérée (Vt) avec la fonction de prédiction de récupération ou la carte de prédiction de récupération lorsque l'alimentation en énergie de la charge électrique (22) est arrêtée, et
générer les informations sur la capacité restante de la batterie rechargeable sur la base de la prédiction de la tension inter-bornes récupérée (Vt).

4. Corps principal d'outil (2) équipé du compteur de batterie (25) selon l'une quelconque des revendications 1 à 3, **caractérisé en ce que** le corps principal d'outil (2) est configuré de sorte que, lorsque l'alimentation en énergie de la charge électrique (22) est lancée (t22) pendant une annonce des informations sur la capacité restante de la batterie rechargeable, l'unité d'annonce (27) interrompe l'annonce des informations sur la capacité restante de la batterie rechargeable.

5. Corps principal d'outil (2) équipé du compteur de batterie (25) selon l'une quelconque des revendications 1 à 4, **caractérisé en ce que** l'unité d'annonce (27) comprend un indicateur (27b) qui indique visuellement les informations sur la capacité restante de la batterie rechargeable.

6. Corps principal d'outil (2) équipé du compteur de batterie (25) selon l'une quelconque des revendications 1 à 5, **caractérisé en ce que** l'unité d'annonce (27) comprend un générateur de voix qui génère une voix afin d'annoncer les informations sur la capacité restante de la batterie rechargeable.

7. Corps principal d'outil (2) équipé du compteur de batterie (25) selon l'une quelconque des revendications 1 à 6, **caractérisé en ce que** la charge électrique (22) est un moteur (22).

8. Outil électrique (1) **caractérisé par** :
le corps principal d'outil (2) équipé du compteur de batterie (25) selon l'une quelconque des revendications 1 à 7.
